**Europäisches Patentamt**

**European Patent Office**

**Office européen des brevets**

(19)

(11) Veröffentlichungsnummer: **0 027 545**
**B1**

# EUROPÄISCHE PATENTSCHRIFT

(45) Veröffentlichungstag der Patentschrift:
**22.02.84**

(21) Anmeldenummer: **80105483.4**

(22) Anmeldetag: **12.09.80**

(51) Int. Cl.³: **H 04 N 3/15,** H 04 N 9/04,
H 01 L 31/04

(54) Monolithisch integrierte Schaltung zur zeilenweisen Bildabtastung und Verfahren zu deren Betrieb.

(30) Priorität: **28.09.79 DE 2939403**

(43) Veröffentlichungstag der Anmeldung:
**29.04.81 Patentblatt 81/17**

(45) Bekanntmachung des Hinweises auf die Patenterteilung:
**22.02.84 Patentblatt 84/8**

(84) Benannte Vertragsstaaten:
**BE FR GB IT NL**

(56) Entgegenhaltungen:
**DE - A - 2 445 490**
**DE - A - 2 605 905**
**DE - A - 2 838 098**
**DE - B - 2 553 686**

**IEEE TRANSACTIONS ON ELECTRON DEVICES, Vol.**
**ED-25, No. 2, February 1978, New York, JAMES M.**
**WHITE, SAVVAS G. CHAMBERLAIN "A Multiple-Gate**
**CCD-Photodiode Sensor Element for Imaging Arrays"**
**Seiten 125-131**
**Tagungsband zur 5. Jahrestagung der FKTG vom 19.-23.**
**September 1977, Seiten 219-223**

(73) Patentinhaber: **SIEMENS AKTIENGESELLSCHAFT,**
**Berlin und München Wittelsbacherplatz 2,**
**D-8000 München 2 (DE)**

(72) Erfinder: **Herbst, Heiner, Dr., Anechostrasse 29 a,**
**D-8000 München 82 (DE)**
Erfinder: **Niemeyer, Matthias, Dipl.-Phys.,**
**Clemensstrasse 12, D-8000 München 40 (DE)**

## Monolithisch integrierte Schaltung zur zeilenweisen Bildabtastung und Verfahren zu deren Betrieb

Die Erfindung bezieht sich auf eine monolithisch integrierte Schaltung zur zeilenweisen Bildabtastung nach dem Oberbegriff des Anspruchs 1 und auf ein Verfahren zum Betrieb derselben.

Eine Schaltung dieser Art ist aus der europäischen Patentanmeldung EP-A1-8 673 oder der deutschen Offenlegungsschrift DE-A-2 838 098 bekannt. Andere Schaltungen, die dem Oberbegriff des Patentanspruchs entsprechen oder sich von diesem nur dadurch unterscheiden, daß sich die beiden parallelen Reihen von optoelektronischen Sensorelementen auf zwei getrennten, linearen CTD-Bildsensoren befinden, sind der europäischen Patentanmeldung EP-A1-8 672 zu entnehmen.

Dem Tagungsband zur 5. Jahrestagung der FKTG (Fernseh- und Kinotechnische Gesellschaft e. V.) vom 19. bis 23. September 1977, Seiten 219 bis 223, insbesondere Bild 8, ist eine Schaltung zu entnehmen, bei der zum Unterschied vom Oberbegriff des Patentanspruchs 1 drei lineare Bildsensoren vorhanden sind, die jeweils eine der drei Gruppen von Sensorelementen enthalten. Andererseits wird in dieser Veröffentlichung auch auf eine Schaltung hingewiesen, die eine einzige CCD-Zeile mit vorgeschalteten Farbstreifenfiltern zum Zwecke der Farbteilung aufweist. Den einzelnen Sensorelementen sind hierbei jeweils Farbfilter mit unterschiedlichen, gruppenspezifischen Spektralbereichen zugeordnet. Der Filter-Spektralbereich der ersten Gruppe von Sensorelementen entspricht der Grundfarbe Grün während den anderen beiden Gruppen in entsprechender Weise die Grundfarben Rot und Blau zugeordnet sind.

Aus den »IEEE Transactions on Electron Devices« Vol. ED-25, No. 2, Febr. 1978, Seiten 125 bis 131 ist ein Bildsensor bekannt, bei dem neben jedem Sensorelement ein gate und neben diesem ein Überlaufgebiet (drain diffusion) angeordnet sind, die ein Überstrahlen (blooming) der Sensorelemente durch Abführen zuviel erzeugter Ladungen verhindern. Demselben Zweck dient auch in der DE-B1-2 553 686 ein sogenannter Überlaufkanal, der eine Reihe von Sensorelementen mäanderförmig umgibt.

Schließlich ist in dem BBC-Report RD 1973/32, November 1973 »Solid State Sensores: The Use of a Single Dimension 512 Element Array for Film Scanning«, herausgegeben von der British Broadcasting Corporation, auf den Seiten 1 bis 17 eine mit einem linearen Bildsensor bestückte Anordnung zum Abtasten der Bilder eines kontinuierlich bewegten 8-mm-Films angegeben, die ein die Bildinformation enthaltendes Fernsehsignal liefert.

Bei einer Bestückung von farbtüchtigen linearen Bildsensoren mit Fotodioden hat sich jedoch deren unterschiedliche spektrale Lichtempfindlichkeit als nachteilig erwiesen.

Der Erfindung liegt die Aufgabe zugrunde, eine Schaltung der eingangs genannten Art anzugeben, die unterschiedliche spektrale Lichtempfindlichkeiten der einzelnen Sensorelemente durch eine einfache Steuerung ihrer Integrationszeiten gegeneinander ausgleicht. Diese Aufgabe wird erfindungsgemäß durch die im Anspruch 1 gekennzeichneten Merkmale gelöst.

Der mit der Erfindung erzielbare Vorteil liegt insbesondere in der einfachen, über die Überlauf-Gates erfolgenden Steuerung der Integrationszeiten und in der hiermit erzielten Erhöhung der Farbtüchtigkeit des Bildsensors.

Bei der oben erwähnten Schaltung aus den »IEEE Transactions . . .« ist zwar ebenfalls eine Steuerung der Integrationszeiten der Sensorelemente vorgesehen, doch erfolgt sie dort zum Zwecke der Anpassung der Integrationszeiten an unterschiedliche Belichtungsintensitäten im Sinne einer »elektronischen Blende«. Eine Farbbildabtastung ist hierbei nicht vorgesehen. Die Steuerung der Integrationszeiten erfolgt über ein zusätzlich vorgesehenes Gate, das den Halbleiterbereich zwischen einer Reihe von Fotodioden und diesen zugeordneten Speicherkondensatoren überdeckt.

Die Erfindung wird nachfolgend anhand der Zeichnung näher erläutert. Dabei zeigt
Fig. 1 ein Ausführungsbeispiel der Erfindung,
Fig. 2 einen Querschnitt durch die Schaltung nach Fig. 1 entlang der Linie II-II und
Fig. 3 Spannungs-Zeit-Diagramme zur Erläuterung der Schaltung nach Fig. 1.

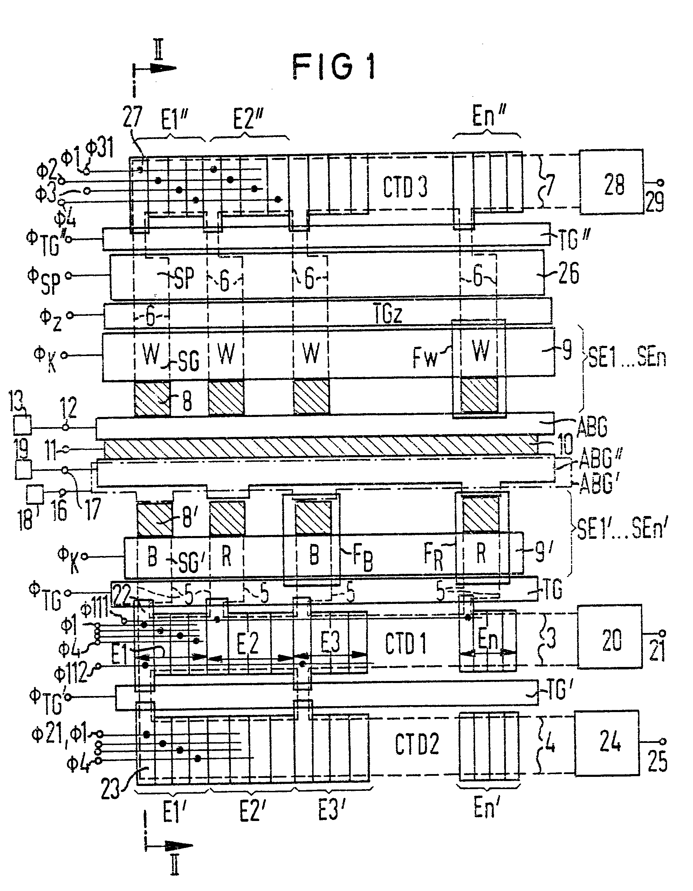

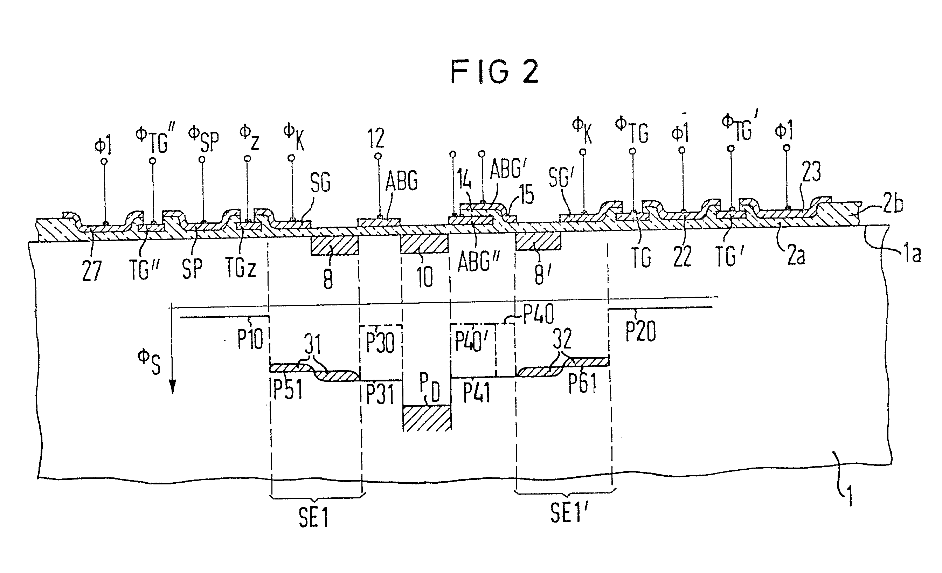

In den Fig. 1 und 2 ist ein nach der Erfindung ausgebildeter linearer Bildsensor dargestellt, der auf einem dotierten Halbleiterkörper 1, z. B. aus p-leitendem Silizium, aufgebaut ist. Der Halbleiterkörper 1 ist an seiner Grenzfläche 1a mit einer elektrisch isolierenden Schicht, z. B. aus $SiO_2$, bedeckt, die Dünnschichtbereiche 2a und Dickschichtbereiche 2b aufweist. Zwischen den in Fig. 1 gestrichelten Linien 3, 4, 5, 6 und 7 liegen Dünnschichtbereiche 2a, außerhalb derselben Dickschichtbereiche. Im Falle einer $SiO_2$-Schicht werden die ersteren auch als Gateoxid-, die letzteren als Feldoxidbereiche bezeichnet.

Eine erste Reihe von optoelektronischen Sensorelementen ist mit SE1 bis SEn bezeichnet. Das Sensorelement SE1 besteht aus einem an der Grenzfläche 1a angeordneten, zu dem Halbleiterkörper 1 entgegengesetzt dotierten, im betrachteten Fall also n-leitenden, Gebiet 8 und einem zu diesem benachbarten MIS-Kondensator. Unter der Bezeichnung MIS wird eine Struktur aus einer leitenden Schicht und einer Halbleiterschicht verstanden, welche durch eine dünne elektrisch isolierende Schicht voneinander getrennt sind. Der genannte MIS-Kondensator besitzt eine Elektrode SG, die durch den Teil einer streifenförmigen, elektrisch leitenden Belegung 9 gebildet wird, der oberhalb des durch die Linien 6 begrenzten Gateoxidbereiches liegt. Die anderen Sensorelemente der Reihe SE1 ... SEn sind entsprechend aufgebaut.

Mit SE1' ... SEn' ist eine zweite Reihe von optoelektronischen Sensorelementen bezeichnet. Das Sensorelement SE1' besteht dabei aus einem umdotierten, an der Grenzfläche 1a angeordneten Gebiet 8' und einem diesem benachbarten MIS-Kondensator, dessen Elektrode SG' aus dem Teil einer streifenförmigen, elektrisch leitenden Belegung gebildet wird, der oberhalb des durch die Linien 5 begrenzten Gateoxidbereiches liegt. Die übrigen Sensorelemente dieser Reihe sind entsprechend ausgebildet.

Die Sensorelemente sind zu drei Gruppen zusammengefaßt, von denen die erste aus den mit W bezeichneten Sensorelementen SE1 ... SEn besteht, während aufeinanderfolgende Sensorelemente der Reihe SE1' ... SEn' abwechselnd der zweiten, mit B gekennzeichneten und der dritten, mit R gekennzeichneten Gruppe angehören. Sämtliche Sensorelemente der ersten Gruppe sind mit Farbfiltern erster Art abgedeckt, von denen eines durch einen Rahmen $F_W$ angedeutet ist, die Sensorelemente der zweiten Gruppe mit Farbfiltern zweiter Art, die durch einen Rahmen $F_B$ dargestellt sind, und die Sensorelemente der dritten Gruppe mit Farbfiltern dritter Art, die durch einen Rahmen $F_R$ angedeutet werden. Die Farbfilter zweiter Art ($F_B$) und dritter Art ($F_R$) weisen unterschiedliche spektrale Empfindlichkeitskurven auf, die den Grundfarben Blau und Rot entsprechen, während die Farbfilter erster Art ($F_W$) Empfindlichkeitskurven aufweisen, die etwa den ganzen Bereich des sichtbaren Lichts umfassen, wobei sie einen Bereich maximaler Empfindlichkeit im Spektralbereich der Grundfarbe Grün besitzen. Andererseits können die Farbfilter $F_W$ auch eine Empfindlichkeitskurve haben, die im Spektralbereich der Grundfarbe Grün liegt.

Zwischen den beiden Reihen von Sensorelementen befindet sich ein Überlauf-Draingebiet 10, das entgegengesetzt zum Halbleiterkörper 1 dotiert ist und über einen Anschluß 11 an einer Betriebsspannung $U_{DD}$ liegt. Ein Überlauf-Gate ABG, das auf der isolierenden Schicht 2 angeordnet ist, überdeckt den Halbleiterbereich zwischen den Sensorelementen SE1 ... SEn und dem Überlauf-Draingebiet 10. Das Gate ABG ist dabei über einen Anschluß 12 mit einer Taktimpulsspannungsquelle 13 verbunden.

Zwischen dem Überlauf-Draingebiet 10 und der Reihe der Sensorelemente SE1' ... SEn' befinden sich zwei weitere Überlauf-Gates ABG' und ABG'', von denen das erstere in Fig. 1 strichpunktiert dargestellt ist. Wie aus Fig. 2 hervorgeht, ist das Gate ABG'' auf der isolierenden Schicht 2 angeordnet, während ABG' in einer zweiten Ebene oberhalb von ABG'' liegt und von diesem durch eine isolierende Zwischenschicht 14 getrennt ist. Die Überlaufgates ABG' und ABG'' sind kammförmig ausgebildet und derart gegeneinander versetzt, daß an die Sensorelemente der zweiten Gruppe B die zahnartigen Vorsprünge von ABG' anschließen, während an die Sensorelemente der dritten Gruppe R die zahnartigen Vorsprünge von ABG'' anschließen. Die Überlauf-Gates ABG' und ABG'' weisen Anschlüsse 16 und 17 auf, über die sie an Taktimpulsspannungsquellen 18 und 19 geschaltet sind. Die streifenförmigen leitenden Belegungen 9 und 9' sind über ihre Anschlüsse mit einer Taktimpulsspannung $\Phi K$ beschaltet.

Neben der Reihe der Sensorelemente SE1' ... SEn' ist ein Transfergate TG angeordnet, das durch die isolierende Schicht 2 von der Grenzfläche 1a getrennt ist und über einen Anschluß mit einer Taktimpulsspannung $\Phi_{TG}$ beschaltet ist. Neben dem Transfergate TG sind die Transferelektroden einer im 4-Phasen-Betrieb arbeitenden Auslese-CTD-Anordnung CTD1 vorgesehen, die einen durch die gestrichelten Linien 3 seitlich begrenzten Übertragungskanal überdecken. Die ersten vier mit Taktimpulsspannungen $\Phi 1$ bis $\Phi 4$ beschalteten Transferelektroden stellen ein CTD-Element E1 dar. Von den sich anschließenden CTD-Elementen sind E2, E3 und En dargestellt. Dem Element En sind weitere, nicht dargestellte Elemente und eine Ausgangsstufe 20 nachgeordnet, die einen Anschluß 21 aufweist. Die ersten Transferelektroden der Elemente E1 bis En sind aus leitenden Belegungen gebildet, die die Randzonen des Transfergate TG geringfügig überlappen und von diesen durch eine Zwischenisolierschicht getrennt sind.

Neben der Auslese-CTD-Anordnung CTD1 ist eine weitere solche, in analoger Weise aufgebaute Anordnung CTD2 vorgesehen, deren Elemente mit E1' ... En' bezeichnet sind. Die neben den mit B bezeichneten Sensorelementen angeordneten Elemente von CTD1 weisen jeweils eine in Richtung auf CTD2 verlängerte Transferelektrode, z. B. 22, auf, die einer in Richtung auf CTD1 verlängerten Transferelektrode, z. B. 23, von CTD2 gegenübersteht. Die verlängerten Elektroden, z. B. 22 und 23, überlappen dabei die Randzonen eines zwischen CTD1 und CTD2 liegenden Transfergates TG' geringfügig. TG' ist über einen Anschluß mit $\Phi_{TG}'$ beschaltet. CTD2 weist eine Ausgangsstufe 24 auf, die mit einem Anschluß 25 versehen ist.

Ein weiteres Gate TGz ist neben den MIS-Kondensatoren der Sensorelemente SE1 ... SEn auf der isolierenden Schicht 2 angeordnet. Diesem schließen sich dann eine streifenförmige, leitende Belegung 26 und ein Transfergate TG'' an. Die genannten Teile TGz, 26 und TG'' sind über ihre Anschlüsse jeweils mit Taktimpulsspannungen $\Phi_z$, $\Phi_{Sp}$ und $\Phi_{TG}''$ beschaltet. Diejenigen Teile der Belegung 26, die oberhalb der gestrichelt eingezeichneten Dünnschichtbereiche der Schicht 2 liegen, stellen die Elektroden, z. B. SP, von Speicherkondensatoren dar, die den Sensorelementen SE1 ... SEn individuell zugeordnet sind.

Neben dem Transfergate TG'' ist eine dritte Auslese-CTD-Anordnung CTD3 vorgesehen, die mit $\Phi 1$ bis $\Phi 4$ beschaltete Elemente E1'' ... En''

aufweist. Jeweils eine Transferelektrode, z. B. 27, jedes Elements von CTD3 ist in Richtung auf das Transfergate TG″ verlängert. CTD3 weist eine Ausgangsstufe 28 auf, die mit einem Anschluß 29 versehen ist.

Ein Integrationszyklus T1 beginnt jeweils mit der Vorderflanke 30 eines Taktimpulses $\Phi$K1 (Zeitpunkt t1). Das hierzu gehörende Potential-profil $\Phi_s$ des Halbleiterkörpers 1 an der Grenzfläche 1a im Bereich der Schaltungsteile SG, 8, ABG, 10, ABG″, ABG′, 8′ und SG′ ist in Fig. 2 mit ausgezogenen Linien angedeutet. Mit den Rückflanken der Taktimpulse $\Phi_{z1}$ und $\Phi_{TG1}$ waren die Sensorelemente SE1′ und SE1 schon vor t1 durch die Potentialschwellen P10 und P20 von dem Speicherkondensator SP und von dem Eingang des CTD-Elements E1 unterhalb der Transferelektrode 22 abgetrennt worden. Wegen der zum Zeitpunkt t1 anliegenden Taktimpulse $\Phi_{ABG1}$, $\Phi_{ABG1}′$ und $\Phi_{ABG1}″$ mit den Amplituden U″ treten unterhalb von ABG, ABG′ und ABG″ Potentialwerte P31 und P41 auf, die größer sind als die Potentiale P51 und P61 der unterhalb von SG und SG′ liegenden Bereiche der Sensorelemente SE1 und SE1′. Dabei fließen Ladungen 31, 32, die in SE1 und SE1′ optisch erzeugt werden, in das auf einem Potential $P_D$ liegende Gebiet 10 ab. Zum Zeitpunkt t2, d. h. beim Auftreten der Rückflanke von $\Phi_{ABG1}$, entsteht die Potentialbar-riere P30, die dem Spannungswert U′ entspricht. Damit beginnt die Integrationszeit Ti1 des Sensorelements SE1, das zur Gruppe W gehört. Mit »Integrationszeit« wird die Zeitspanne bezeichnet, in der sich optisch erzeugte Ladungen in den Sensorelementen ansammeln, wobei die Größe der angesammelten Ladungen von den Belichtungsintensitäten und damit von der lokalen Bildinformation abhängt. Mit dem Auf-treten der Rückflanke von $\Phi_{ABG1}′$ zum Zeitpunkt t3 entsteht die Potentialschwelle P40, so daß zu diesem Zeitpunkt die Integrationszeit Ti2 von SE1′ beginnt, welches der Gruppe B angehört. Zum Zeitpunkt t4 tritt dann schließlich die Rückflanke von $\Phi_{ABG1}″$ auf, so daß vor den Sensorelementen der Gruppe R eine Potentialschwelle entsteht, die bewirkt, daß deren Integrationszeit Ti3 ebenfalls beginnt. Vor den Sensorelementen der Gruppe B entsteht durch die Rückflanke von $\Phi_{ABG1}″$ eine weitere Poten-tialschwelle P40′, die aber an dem dort bestehenden Betriebszustand nichts verändert, da ja bereits die Potentialschwelle P40 besteht. Die Integrationszeiten aller Sensorelemente enden mit dem Auftreten der Rückflanke von $\Phi$K zum Zeitpunkt t5, wodurch die in den Integrationszeiten jeweils angesammelten Ladungen, z. B. 31 und 32, bei anliegenden Taktimpulsen $\Phi_{z2}$, $\Phi_{TG2}$, $\Phi_{SP}$ und $\Phi_{111}$ sowie $\Phi_{112}$ in die Speicherkondensatoren SP (Pfeil 33) und in die CTD-Elemente E1 bis En (Pfeil 34) verschoben werden.

Erst danach werden die Ausgänge der Taktimpulsspannungsgeber 13, 18 und 19 auf den Spannungswert U″ umgeschaltet, wodurch die Potentialschwellen P30, P40 und P40′ abgebaut werden, so daß an den Sensorelementen nach Beendigung der Impulse $\Phi_{TG2}$ und $\Phi_{z2}$ und nach dem Auftreten von $\Phi$K2, d. h. zu Beginn eines neuen Integrationszyklus T2, der bereits beschriebene Potentialzustand des Zeitpunkts t1 wieder eingestellt wird.

Der Pfeil 35 bedeutet dann die zum Zeitpunkt der Rückflanke von $\Phi_{112}$ erfolgende Weitergabe der in den Integrationszeiten angesammelten Ladungen, die aus »B«-Sensorelementen stam-men, über das durch $\Phi_{TG}′$ geöffnete Transfergate TG′ in die mit $\Phi_{21}$ beschalteten Elemente E1′, E3′ usw. von CTD2. Somit verbleiben nur die aus »R«-Sensorelementen stammenden Ladungen in jedem zweiten Element von CTD1 unterhalb der mit $\Phi_{111}$ beaufschlagten Elektroden.

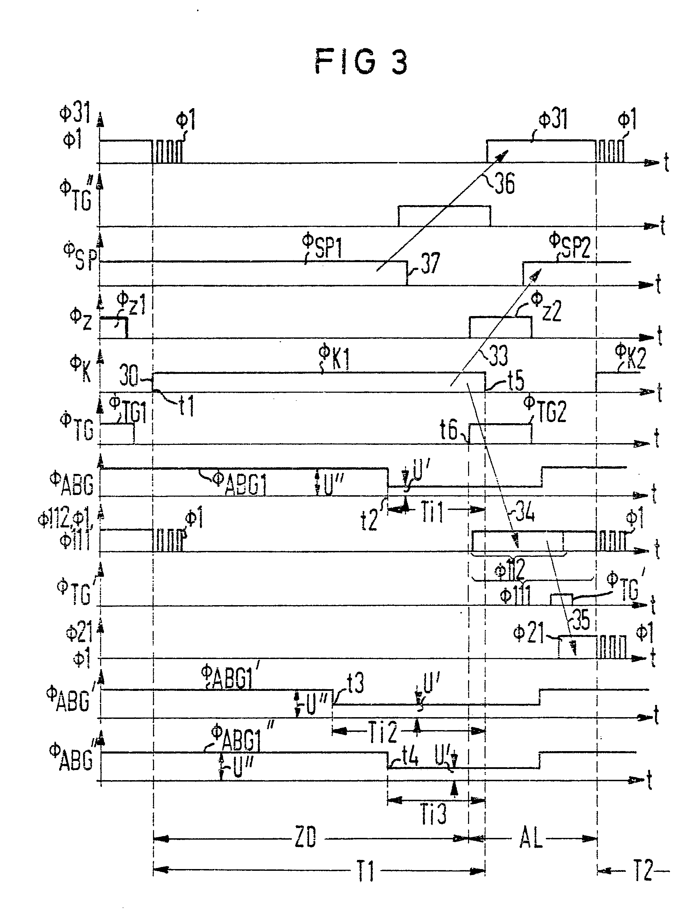

Schon bevor die durch den Pfeil 33 angedeutete Ladungsübertragung stattfindet, waren die Speicher SP mit der Rückflanke 37 von $\Phi_{SP1}$ über das mittels eines Taktimpulses $\Phi_{TG}″$ geöffnete Transfergate TG″ in die mit $\Phi_{31}$ beaufschlagten Elemente E1″ bis En″ von CTD3 ausgelesen worden (Pfeil 36), wobei die während des vorhergehenden, in Fig. 3 nicht dargestellten Integrationszyklus in SP zwischengespeicherten Ladungen weitergegeben werden.

Man geht nun davon aus, daß während des vorhergehenden in Fig. 3 nicht dargestellten Integrationszyklus eine bestimmte Bildzeile eines abzutastenden Farbbildes auf die Reihe der mit W-Filtern versehenen Sensorelemente SE1 ... SEn ausgerichtet war, wobei von ihr W-bewertete Ladungsmengen abgeleitet und in den Speichern SP zwischengespeichert wurden. Während des in Fig. 3 dargestellten Integrationszyklus T1 ist dann infolge der kontinuierlichen Bewegung des abzutastenden Farbbildes dieselbe Zeile auf die Reihe der Sensorelemente SE1′ .... SEn′ ausgerichtet, wobei von ihr B- und R-bewertete Ladungsmengen abgeleitet und in die Elemente von CTD2 und CTD1 ausgelesen werden. Gleichzeitig werden aber auch die zwischengespeicherten W-bewerteten Ladungsmengen aus den Speichern SP in die Elemente von CTD3 ausgelesen. Zu Beginn des Integrationszyklus T2 werden dann die Taktim-pulsspannungen $\Phi_1$ bis $\Phi_4$ angeschaltet, die die W-, R- und B-bewerteten Ladungsmengen bzw. Ladungspakete den Ausgangsstufen 28, 20 und 24 getrennt zuführen. In den Ausgangsstufen werden dann W-, R- und B-Spannungssignale abgeleitet, die an den Anschlüssen 29, 21 und 25 zur Verfügung stehen. Aus diesen Spannungssignalen können sogenannte Farbwertsignale abgeleitet werden, die die Intensitäten der Grundfarben einer Farbbildröhre steuern.

Mit besonderem Vorteil werden die Impulslän-gen der Impulse $\Phi_{ABG1}$, $\Phi_{ABG1}′$ und $\Phi_{ABG1}″$ unterschiedlich bemessen. Da hierdurch die Integrationszeiten Ti1, Ti2 und Ti3 getrennt voneinander einstellbar sind, ist es möglich, die unterschiedliche Empfindlichkeit der Sensorelemente für Licht unterschiedlicher Wellenlänge auszugleichen. So ist es beispielsweise zweckmäßig, in der in Fig. 3 angedeuteten Weise die

Integrationszeit Ti2 der der Gruppe B angehörenden Sensorelemente größer zu wählen als die Integrationszeit Ti3 der zur Gruppe R gehörenden Sensorelemente, weil die Sensorelemente für blaues Licht weniger empfindlich sind als für rotes Licht.

Nach einer weiteren Ausgestaltung der Erfindung können die MIS-Kondensatoren, z. B. SG und SG', der Sensorelemente auch entfallen, so daß diese allein aus den Fotodioden 8 bzw. 8' bestehen. In diesem Fall beginnt und endet der Integrationszyklus jeweils mit den gleichzeitig auftretenden Rückflanken der Taktimpulse $\Phi_{TG}$ und $\Phi_Z$, wobei auch die Integrationszeiten jeweils zu diesem Zeitpunkt enden.

Bei dem behandelten Ausführungsbeispiel, bei dem von einem p-leitenden Halbleiterkörper 1 ausgegangen wird, weisen die angegebenen Potentiale und Spannungen gegenüber dem Bezugspotential der Schaltung, auf dem der Halbleiterkörper 1 liegt, jeweils positive Vorzeichen auf. Werden die Leitfähigkeitstypen der einzelnen Halbleitergebiete durch die jeweils entgegengesetzten ersetzt, so kehren sich auch die Vorzeichen der Spannungen und Potentiale um.

Obwohl die CTD-Anordnungen des angegebenen Ausführungsbeispiels als SCCD-Anordnungen (Surface-Charge-Coupled Device) ausgebildet sind, kann die Erfindung mit bekannten CTD-Anordnungen beliebiger Art ausgeführt werden, wie sie z. B. in dem Buch von Sequin und Tompsett »Charge Transfer Devices«, Academic Press, New York, 1975, auf den Seiten 1 bis 18 beschrieben sind. Die CTD-Anordnungen können dabei entsprechend ihrem Aufbau nach einem der bekannten Verfahren, so z. B. im 2-, 3-, 4- oder Mehrphasenbetrieb, arbeiten.

Der in der Fig. 3 mit ZD bezeichnete Zeitabschnitt stellt die Zeilendauer dar. Dies ist die Zeitspanne, in der die einer Bildzeile entsprechenden Sensorsignale unter dem Einfluß der Taktimpulsspannungen $\Phi 1$ bis $\Phi 4$ an den Ausgängen 29, 21 und 25 abgegeben werden. Sie wird zweckmäßigerweise so gewählt, daß sie der Zeitspanne entspricht, die ein durch die weiterverarbeiteten Sensorsignale gesteuerter Elektronenstrahl eines Bildsichtgeräts braucht, um eine Bildzeile zu schreiben. Innerhalb einer Zeilendauer ZD wird aus der erfindungsgemäßen Schaltung jeweils das in dem unmittelbar vorangegangenen Integrationszyklus erhaltene Zeilensignal ausgelesen. Der zwischen zwei Zeitabschnitten ZD liegende Zeitabschnitt AL wird als Austastlücke bezeichnet. In diesem Zeitabschnitt wird ein das Zeilensignal in einem Wiedergabegerät schreibender Elektronenstrahl ausgetastet und vom Zeilenende zum Zeilenanfang der nächsten Zeile hingeführt. Bei einer Wiedergabe in Fernsehgeräten müssen die Zeitabschnitte ZD und AL der Fernsehnorm entsprechen und betragen jeweils 52 μs und 12 μs.

## Patentansprüche

1. Monolithisch integrierte Schaltung zur zeilenweisen Bildabtastung mit einem linearen Bildsensor, der zwei parallele Reihen von optoelektronischen Sensorelementen (SE1 ... SEn, SE1' ... SEn') aufweist, bei der die Sensorelemente (SE1 ... SEn) der ersten Reihe zu einer ersten Gruppe (W) und die Sensorelemente (SE1' ... SEn') der zweiten Reihe zu zwei weiteren Gruppen (R, B) zusammengefaßt sind und bei der die Sensorelemente (SE1 ... SEn, SE1' ... SEn') hinter Farbfiltern ($F_W$, $F_R$, $F_B$) mit unterschiedlichen, gruppenspezifischen Spektralbereichen angeordnet sind, dadurch gekennzeichnet, daß ein Überlauf-Draingebiet (10) zwischen den beiden Reihen vorgesehen ist, daß zwischen dem Überlauf-Draingebiet (10) und den Sensorelementen jeder Gruppe jeweils eigene Überlauf-Gates (ABG, ABG', ABG'') vorgesehen sind, die mit Taktimpulsspannungsquellen (13, 18, 19) verbunden sind, welche jeweils zwischen einem einer Überlauf-Potentialbarriere (P30, P40, P40') entsprechenden, unteren Spannungswert (U') und einem oberen Spannungswert (U'') mit einem jeder Gruppe (W, B, R) individuell zugeordneten Verhältnis von Impulsdauer zu Impulsperiode alternieren, und daß die Impulsdauer bei den einzelnen Taktimpuls-Spannungsquellen (13, 18, 19) derart unterschiedlich bemessen ist, daß die hierdurch getrennt voneinander einstellbaren, gruppenspezifischen Integrationszeiten (Ti1, Ti2, Ti3) zum Ausgleich zwischen den unterschiedlichen Empfindlichkeiten der Sensorelemente (SE1 ... SEn, SE1' ... SEn') für Licht unterschiedlicher Wellenlänge dienen.

2. Schaltung nach Anspruch 1, dadurch gekennzeichnet, daß die Impulsdauer bei der Taktimpulsspannungsquelle (19), die den auf die Grundfarbe Rot ansprechenden Sensorelementen der ersten weiteren Gruppe (R) zugeordnet ist, im Verhältnis zur Impulsperiode größer gewählt ist als bei der Taktimpulsspannungsquelle (18), die den auf die Grundfarbe Blau ansprechenden Sensorelementen der zweiten weiteren Gruppe (B) zugeordnet ist.

3. Schaltung nach Anspruch 2, dadurch gekennzeichnet, daß die zwei den beiden weiteren Gruppen (B, R) zugeordneten Überlauf-Gates (ABG', ABG'') bei einer jeweils kammförmigen Ausbildung in zwei verschiedenen Ebenen angeordnet und derart gegeneinander versetzt sind, daß zwischen dem Überlauf-Draingebiet (10) und den Sensorelementen der ersten weiteren Gruppe (R) jeweils die zahnartigen Vorsprünge des ersten Überlauf-Gates (ABG'') liegen, während zwischen dem Überlauf-Draingebiet (10) und den Sensorelementen der zweiten weiteren Gruppe (B) sowohl die zahnartigen Vorsprünge des zweiten Überlauf-Gates (ABG') als auch Teile des ersten Überlauf-Gates (ABG'') angeordnet sind.

4. Schaltung nach einem der Ansprüche 1 bis 3, dadurch gekennzeichnet, daß die Sensorelemente aus Fotodioden (8, 8') bestehen.

5. Schaltung nach einem der Ansprüche 1 bis 3, dadurch gekennzeichnet, daß die Sensorelemente aus MIS-Kondensatoren (SG, SG') und diesen benachbarten Fotodioden (8, 8') bestehen.

6. Verfahren zum Betrieb einer Schaltung nach den Ansprüchen 1 bis 5, dadurch gekennzeichnet, daß zu Beginn jedes Integrationszyklus (T1) alle Überlauf-Gates (ABG, ABG', ABG") mit dem von der zugeordneten Taktimpulsspannungsquelle (13, 18, 19) abgegebenen, oberen Spannungswert (U") beschaltet werden und daß sie nur während eines gruppenspezifischen Teils des Integrationszyklus (T1) mit dem von der jeweiligen Taktimpulsspannungsquelle (13, 18, 19) abgegebenen, der Überlauf-Potentialbarriere (P30, P40, P40') entsprechenden, unteren Spannungswert (U') beaufschlagt werden.

## Claims

1. A monolithic integrated circuit for row-by-row image scanning, with a linear image sensor possessing two parallel rows of opto-electronic sensor elements (SE1 ... SEn, SE1' ... SEn'), where the sensor elements (SE1 ... SEn) of the first row are combined to form a first group (W) and the sensor elements (SE1' ... SEn') of the second row are combined to form two further groups (R, B), and where the sensor elements (SE1 ... SEn, SE1' ... SEn') are arranged behind colour filters ($F_W$, $F_R$, $F_B$) which possess different, group-specific spectral zones, characterised in that an overflow drain zone (10) is arranged between the two rows, that individual overflow gates (ABG, ABG', ABG") are arranged between the overflow drain zone (10) and the sensor elements of each group and are connected to respective clock pulse voltage sources (13, 18, 19), each of which alternates between a lower voltage value (U') which corresponds to an overflow potential barrier (P30, P40, P40') and an upper voltage (U"), with a ration of pulse duration to pulse period which is individually assigned to each group (W, B, R), and that the pulse duration of the individual clock pulse voltage sources (13, 18, 19) are contrived to differ in such manner that the group-specific integration times (Ti1, Ti2, Ti3) which can thus be set separately from one another serve to compensate between the different sensitivities of the sensor elements (SE1 ... SEn, SE1' ... SEn') to light of different wavelengths.

2. A circuit as claimed in Claim 1, characterised in that the clock pulse voltage source (19) assigned to those sensor elements of the first further group (R) which respond to the basic colour red has a pulse duration relative to the pulse period selected to be greater than that of the clock pulse voltage source (18) assigned to those sensor elements of the second further group (B) which respond to the basic colour blue.

3. A circuit as claimed in Claim 2, characterised in that the two overflow gates (ABG', ABG") which are assigned to the two further groups (B, R) are arranged in two different planes in a comb-like design and are offset from one another in such manner that the teeth-like projections of the first overflow gate (ABG") are located between the overflow drain zone (10) and the sensor elements of the first further group (R), whereas both the teeth-like projections of the second overflow gate (ABG') and parts of the first overflow gate (ABG") are arranged between the overflow drain zone (10) and the sensor elements of the second further group (B).

4. A circuit as claimed in one of the Claims 1 to 3, characterised in that the sensor elements consist of photo-diodes (8, 8').

5. A circuit as claimed in one of the Claims 1 to 3, characterised in that the sensor elements consist of MIS-capacitors (SG, SG') and photo-diodes (8, 8') adjacent to the capacitors.

6. A process for operating a circuit as claimed in Claims 1 to 5, characterised in that at the beginning of each integration cycle (T1) all the overflow gates (ABG, ABG', ABG") are connected to the upper voltage value (U") which is emitted from the assigned clock pulse voltage source (13, 18, 19), and that only during a group-specific part of the integration cycle (T1) are they connected to the lower voltage value (U') which is emitted from the clock pulse voltage source in question (13, 18, 19) and which corresponds to the overflow potential barrier (P30, P40, P40').

## Revendications

1. Circuit intégré monolithiquement pour l'exploration ligne par ligne d'une image à l'aide d'un détecteur d'image linéaire qui comporte deux rangées parallèles d'éléments détecteurs optoélectriques (SE1 ... SEn, SE1' ... SEn'), dans lequel les éléments détecteurs (SE1 ... SEn) de la première rangée sont réunis en un premier groupe (W) et les éléments détecteurs (SE1' ... SEn') de la seconde rangée sont réunis en un second groupe (R, B), et dans lequel les éléments détecteurs (SE1 ... SEn, SE1' ... SEn') sont disposés derrière des filtres chromatiques ($F_W$, $F_R$, $F_B$) possédant des gammes spectrales différentes spécifiques aux groupes, caractérisé par le fait qu'une zone de drain de dépassement de capacité (10) est prévue entre les deux rangées, qu'entre la zone de drain de dépassement de capacité (10) et les éléments détecteurs de chaque groupe sont respectivement prévues des portes de dépassement de capacité propres (ABG, ABG', ABG") qui sont couplées à des sources de tension d'impulsions de cadence (13, 18, 19) qui alternent respectivement entre une valeur de tension inférieure (U') correspondant à une barrière de potentiel de dépassement de capacité (P30, P40, P40') et une valeur de tenison supérieure (U''), avec un rapport de la durée des impulsions à la période d'impulsions qui est associé individuellement à chaque groupe (W, B, R), et que les durées des impulsions pour les sources de tension d'impulsions de cadence (13, 18, 19) individuelles sont dimensionnées de façon différente de manière que les durées d'intégration (Ti1, Ti2, Ti3) spécifiques aux groupes et pouvant de ce fait être réglées de façon distincte les unes des autres servent à la compensation entre les différentes sensibilités des éléments détecteurs (SE1 ... SEn, SE1' ... SEn') pour de la lumière possédant une longueur d'onde différente.

2. Circuit suivant la revendication 1, caractérisé par le fait que la durée des impulsions dans le cas de la source de tension d'impulsions de cadence (19), qui est associée aux éléments détecteurs, répondant à la couleur primaire rouge, du premier autre groupe (R), est choisi plus important par rapport à la période des impulsions que dans le cas de la source de tension d'impulsions de cadence (18) qui est associée aux éléments détecteurs, répondant à la couleur primaire bleue, du second autre groupe (B).

3. Circuit suivant la revendication 2, caractérisé par le fait que dans le cas d'une configuration respective en forme de peigne, les deux portes de dépassement de capacité (ABG', ABG''), qui sont associées aux deux autres groupes (B, R), sont disposées dans deux plans différents et sont décalées l'une par rapport à l'autre de manière que les avancées en forme de dents de la première porte de dépassement de capacité (ABG'') se trouvent respectivement entre la zone de drain de dépassement de capacité (10) et les éléments détecteurs du premier autre groupe (R), tandis qu'aussi bien les avancées en forme de dents de la seconde porte de dépassement de capacité (ABG') qu'également des parties de la première porte de dépassement de capacité (ABG'') sont disposées entre la zone de drain de dépassement de capacité (10) et les éléments détecteurs du second autre groupe (B).

4. Circuit suivant une des revendications 1 à 3, caractérisé par le fait que les éléments détecteurs sont constitués par des photodiodes (8, 8').

5. Circuit suivant une des revendications 1 à 3, caractérisé par le fait que les éléments détecteurs sont constitués par des condensateurs MIS (SG, SG') et des photodiodes (8, 8') voisins de ceux-ci.

6. Procédé pour la mise en oeuvre d'un circuit suivant les revendications 1 à 5, caractérisé par le fait qu'au début de chaque cycle d'intégration (T1) toutes les portes de dépassement de capacité (ABG, ABG', ABG'') sont reliées à la valeur de tension supérieure (U'') délivrée par la source de tension d'impulsions de cadence associée (13, 18, 19), et qu'elles ne sont reliées à la valeur de tension inférieure (U'), qui est délivrée par la source de tension d'impulsions de cadence respective (13, 18, 19) et qui correspond à la barrière de potentiel de dépassement de capacité (P30, P40, P40'), que pendant une partie du cycle d'intégration (T1) qui est spécifique aux groupes.

# FIG 1

# FIG 2

FIG 3